Europäisches Patentamt

European Patent Office

Office européen des brevets

(19)

(11) Publication number: 0 317 323
A2

# (12) EUROPEAN PATENT APPLICATION

(21) Application number: 88310878.9

(51) Int. Cl.⁴: $G\ 11\ C\ 17/00$

(22) Date of filing: 17.11.88

(30) Priority: 17.11.87 JP 288375/87

(43) Date of publication of application:
24.05.89 Bulletin 89/21

(84) Designated Contracting States: DE FR GB

(71) Applicant: KABUSHIKI KAISHA TOSHIBA
72, Horikawa-cho Saiwai-ku
Kawasaki-shi Kanagawa-ken 210 (JP)

(72) Inventor: Masuoka, Fujio c/o Patent Division
Toshiba Corporation Princ. Office 1-1-1, Shibaura
Minato-ku Tokyo (JP)

Momodomi, Masaki c/o Patent Division
Toshiba Corporation Princ. Office 1-1-1, Shibaura
Minato-ku Tokyo (JP)

Ito, Yasuo c/o Patent Division
Toshiba Corporation Princ. Office 1-1-1, Shibaura
Minato-ku Tokyo (JP)

Iwata, Yoshihisa c/o Patent Division
Toshiba Corporation Princ. Office 1-1-1, Shibaura
Minato-ku Tokyo (JP)

Chiba, Masahiko c/o Patent Division
Toshiba Corporation Princ. Office 1-1-1, Shibaura
Minato-ku Tokyo (JP)

Shirota, Riichiro c/o Patent Division
Toshiba Corporation Princ. Office 1-1-1, Shibaura
Minato-ku Tokyo (JP)

Iwahashi, Hiroshi c/o Patent Division
Toshiba Corporation Princ. Office 1-1-1, Shibaura
Minato-ku Tokyo (JP)

(74) Representative: Sturt, Clifford Mark et al
MARKS & CLERK 57-60 Lincoln's Inn Fields
London WC2A 3LS (GB)

(54) Programmable semiconductor memory.

(57) Memory cells (11) are divided into a plurality of series circuit units arranged in matrix fashion and comprising a plurality memory cells connected in series. The memory cells each consists of non-volatile transistors having a control gate electrode, a floating gate electrode and an erase gate electrode. One end of each series circuit unit is coupled to a bit line (12) with the circuit units in a given row of circuit units being coupled to the same bit line. Column lines (14) are provided wherein each circuit unit in a given column of circuit units has the control gate electrodes of its memory cells coupled to a column line, the control gate electrodes of each memory cell in a given column of memory cells being connected to a common column line. A voltage by which the selected non-volatile transistor is driven to its saturation state is applied to the control gate electrode of the selected transistor through the corresponding column line, thereby injecting hot electrons from the semi-conductor substrate into the floating gate electrode. Another voltage by which the non-selected non-volatile transistor is driven to its non-saturation state is applied to the control gate electrodes of the remaining non-selected non-volatile transistors of the series circuit unit.

FIG. 2.

EP 0 317 323 A2

Bundesdruckerei Berlin

## Description

### PROGRAMMABLE SEMICONDUCTOR MEMORY

This invention generally relates to a programmable semiconductor memory using non-volatile transistors as memory cells from which data can be electrically erased. It particularly relates to a non-volatile semiconductor memory in which data stored in a plurality of memory cells may be erased simultaneously or in units of a row. Data may be written to the memory a cell (or bit) at a time.

Non-volatile semiconductor memories from which data may be erased are known as EPROMs (Erasable and Programmable Read Only Memories). EPROMs from which the data may be erased electrically are called $E^2$ PROMs (Electrically erasable PROMS). $E^2$ PROMs have been developed which permit the simultaneous erasure of data stored in a plurality of memory cells. Such an $E^2$ PROM is disclosed in "A 128K Flash EEPROM Using Double Polysilicon Technology", pp. 76-77 of "1987 IEEE International Solid State Circuits Conference, Digest of Technical Papers."

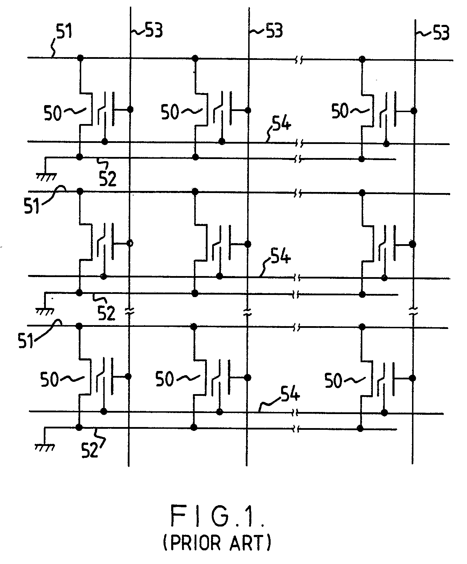

Figure 1 is a circuit diagram depicting a memory cell array of a prior art $E^2$ PROM in which the data stored in the memory cells may be erased simultaneously. In the Figure, memory cells 100 consist of non-volatile transistors having a floating gate electrode, a control gate electrode and an erase gate electrode. Data erasure may be effected electrically. Memory cells 100 are arranged in rows (disposed vertically) and columns (disposed horizontally). The drains of the memory cells 100 in a given column are commonly connected to one of bit lines 101. The sources of the memory cells 100 in a given column are commonly connected to one of ground lines 102. The control gate electrodes of the memory cells 100 in a given row are commonly connected to one of row lines 103. Finally, the erase gate electrodes of the memory cells 100 in a given column are commonly connected to one of erase lines 104. Such a memory cell array is disclosed in U.S. Patent No. 4,437,174.

In such a prior art $E^2$ PROM, each memory cell consists of a single non-volatile transistor which may contain a single bit of data. Each memory cell is connected to a corresponding bit line, ground line, row line and erase line. Thus, in such a configuration, four wires, namely, the bit line, ground line, row line and erase line, are required for each bit. Furthermore, the drain of each cell consists of a diffusion region and the bit line consists of a metal wire of, for example, aluminum. Thus when a cell is connected to its corresponding bit line, a contact is required. The position of formation of a contact usually requires an area wider than the wire width. This makes it difficult to attain high integration densities of the cells. A large number of contacts lowers the manufacturing yield.

The present invention overcomes the above-noted problems of the prior art by reducing the number of wires required for each bit or cell and reducing the number of contacts coupling the cells to the bit lines.

Accordingly, an object of this invention is to provide a non-volatile semiconductor memory wherein a high integration density can be achieved by reducing the number of wires and the number of contacts.

Another object of this invention is to provide a non-volatile semiconductor memory with a low manufacturing cost.

Yet another object of this invention is to provide a non-volatile semiconductor memory which permits an increased production yield.

The non-volatile semiconductor memory of this invention comprises a plurality of series circuit units arranged in a row and column matrix with each series circuit unit having at least two memory cells connected in series. Each memory cell consists of a non-volatile transistor having a control gate electrode, a floating gate electrode, and an erase gate electrode. Data stored in the memory cells may be erased electrically. One end of each series circuit unit is coupled to a bit line, the circuit units in a given row of circuit units being coupled to the same bit line. The control gate electrodes of the memory cells in a given column of memory cells are coupled to the same column line and the erase gate electrodes of the memory cells in a given series circuit unit are commonly coupled to an erase line; the circuit units in a given row of circuit units being coupled to the same erase line.

A more complete appreciation of the invention and many of the attendant advantages thereof will be readily appreciated as the invention becomes better understood by reference to the following detailed description when considered in connection with the accompanying drawings, wherein:

Figure 1 is a circuit diagram of a prior art non-volatile semiconductor memory.

Figure 2 is a circuit diagram of one embodiment of this invention.

Figure 3 is a plan view of a pattern showing the memory cell array of the circuit diagram corresponding to Figure 2.

Figure 4 and Figure 5 are cross-sectional views taken along lines I - I', II - II'', respectively, of Figure 3.

Figure 6 is a circuit diagram showing the entire layout, including peripheral circuitry, of the memory of Figure 1.

Figure 7, Figure 8 and Figure 11 are timing charts of the memory of the above embodiment.

Figure 9 and Figure 10 are cross-sectional views showing the non-volatile transistors which are provided with a floating gate electrode and a control gate electrode.

Figure 12 is a circuit diagram showing the entire layout, including peripheral circuitry, of the memory of a further embodiment.

Figure 13 is a plan view of a pattern showing the memory cell array of the circuit diagram corresponding to Figure 12.

Figure 14 and Figure 15 are cross-sectional views taken along lines I - I', II - II', respectively, of Figure 13.

Figure 16 shows a detailed portion of the column decoders of Figures 6 and 12.

Figure 17 is a circuit diagram of a column group decoder.

Figure 18 is a circuit diagram of a column group decoder buffer.

Figure 19 is a circuit diagram of a column part decoder.

Figure 20 is a table showing the various inputs to the column part decoder of a column decoder.

Figure 21 is a circuit diagram of a decode-output buffer.

Figure 22 is a circuit diagram of an oscillation circuit which generates clock signals for use in the circuits of Figure 18 and Figure 21.

Figure 23 is a circuit diagram of a pull-up circuit which generates voltages used in a column decoder.

Figure 24 is a circuit diagram of a further embodiment of this invention.

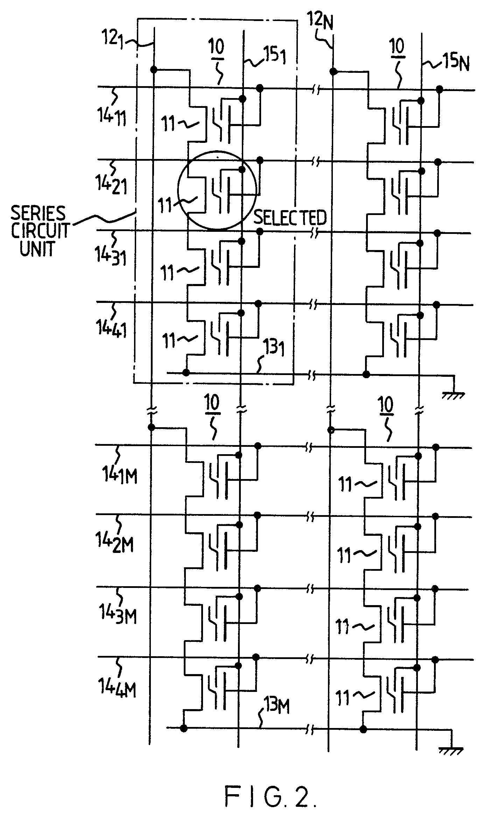

Figure 2 is a circuit diagram of a memory cell array in which the present invention is applied to an $E^2$ PROM (hereafter referred to simply as "memory"). In the Figure, series circuit unit 10 includes four memory cells 11 connected in series. Each memory cell 11 of series circuit unit 10 consists of a non-volatile transistor having: a source region; a drain region; a floating gate electrode arranged above the channel region between the source and drain regions; a control gate electrode; and an erase gate electrode arranged so as to overlap the floating gate electrode. Data stored in a memory cell 11 may be erased electrically.

Generally, the present invention may be applied to what may be termed programmable memories. Programmable memory as used herein refers to any kind of semiconductor memory which can be programmed before, during, or after fabrication or manufacture. It may include, but should not be limited ton, non-volatile memories, MASKROMs, SRAMs, and DRAMs.

A plurality of these series circuit units 10 are arranged in matrix fashion as shown in Figure 2. The series circuit units are disposed in rows and columns. As used herein, "row" refers to that which extends vertically or from top to bottom as viewed in Figure 2. "Column" refers to that which extends horizontally or from left to right as viewed in Figure 2. For clarity in subsequent discussion, it should be noted that each column of series circuit units in Figure 2 includes four columns of memory cells, the control gates of the memory cells disposed in a given column of memory cells being coupled to the same one of column lines 14. Although these terms have been defined for clarity of description, they should not be read to limit in any way the scope of the invention, but rather to facilitate understanding. One end of each series circuit unit 10 is coupled to one of bit lines $12_1, \ldots 12_N$, with the series circuit units in a given row of series circuit units being coupled to the same bit line. The other end of each series circuit unit 10 is coupled to one of ground

lines $13_1, \ldots 13_M$, with the series circuit units in a given column of series circuit units being coupled to the same ground line. A voltage of 0V is maintained across ground lines 13. The erase gate electrodes of each memory cell in a series circuit unit are coupled to a common erase line 15, with the series circuit units in a given row being coupled to the same erase line. The control gate electrode of each memory cell in a series circuit unit is coupled to a column line 14, with each memory cell in a given column of memory cells being coupled to the same column line. Thus, in the embodiment of Figure 2, column lines $14_1$, $14_2$, $14_3$, $14_4$ are coupled respectively to each of the four memory cells comprising a series circuit unit.

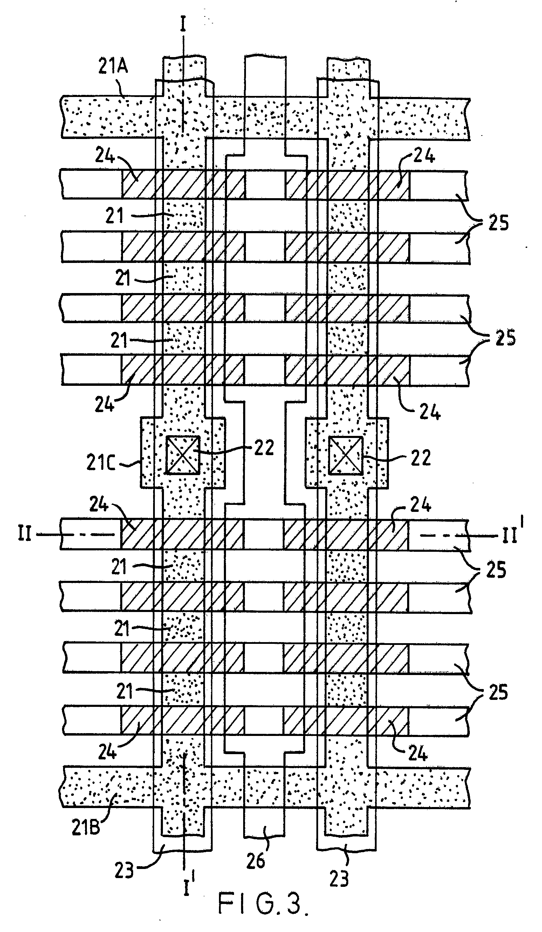

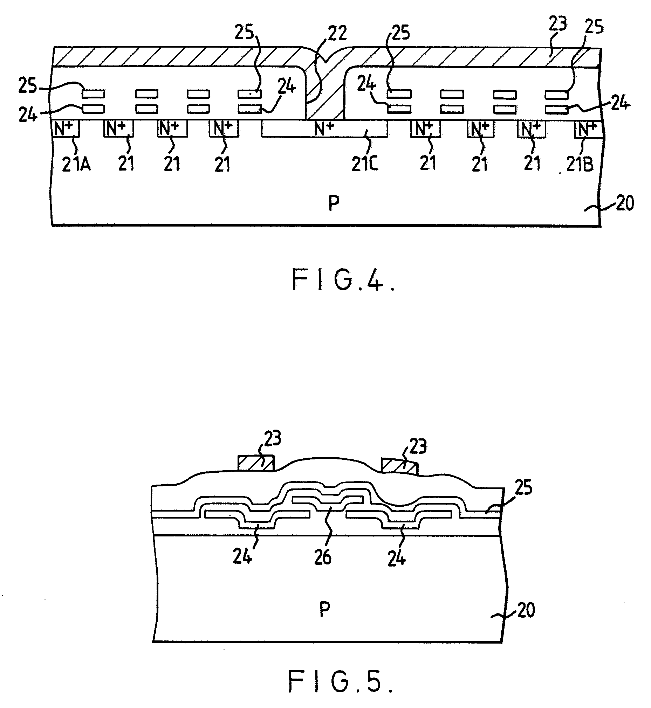

Figure 3 is a plan view corresponding to the structure of the memory cell array circuit shown in Figure 2 when such a memory is actually provided on a semiconductor chip. Figure 4 is a cross-sectional view along the line I - I' in Figure 3. Figure 5 is a cross-sectional view along the line II- II' in Figure 3.

In this embodiment, a P-type silicon semiconductor substrate is used as the substrate 20 of the memory. Separate N+ type regions 21, providing the source and drain regions of the four memory cells 11 in each series circuit unit 10, are formed in the surface region of the substrate 20. N+ regions 21A and 21B, positioned in the uppermost and lowermost portions of Figure 3 respectively, are common to neighboring series circuit units 10. N+ regions 21A and 21B are used as ground lines 13. Metal wires 23 of aluminum, for example, are coupled through contact holes 22 to each of the N+ type regions 21C located between N+ regions 21A and 21B. Metal wires 23 are used as bit lines 12. Electrodes 24, made of a first polycrystalline silicon layer and put in a floating electrical state, are formed between adjacent N+ type regions 21 and are insulated therefrom by an insulating film. Electrodes 24 are the floating gate electrodes of memory cells 11. Electrodes 25, made of a third polycrystalline silicon layer, are formed over the plurality of electrodes 24 shown in Figure 3, insulated therefrom by an insulating film. Electrodes 25 are the control gate electrodes and serve as the column lines 14 of each memory cell 11. Electrodes 26, made of a second polycrystalline silicon layer, are formed between adjacent rows of series circuit units 10, insulated therefrom by an insulating film. These electrodes 26 overlap a portion of electrodes 24 made of the first polycrystalline layer. Electrodes 26 are the erase gate electrodes and serve as the erase line 15 coupled to each memory cell 11.

In this embodiment of the memory, each series circuit unit 10 consists of four memory cells 11 connected in series. In practice various numbers of memory cells may be used and the invention should not be understood as limited in this respect. One end of each series circuit 10 is coupled to a bit line 12 which is embodied in metal wire 23 while the other end is coupled to a ground line 13 which is embodied in N+ region 21A or 21B. The control gate electrode of each memory cell 11 is coupled to a column line 14 embodied in electrode 25 and the erase gate electrode of each memory cell 11 is coupled to an erase line 15.

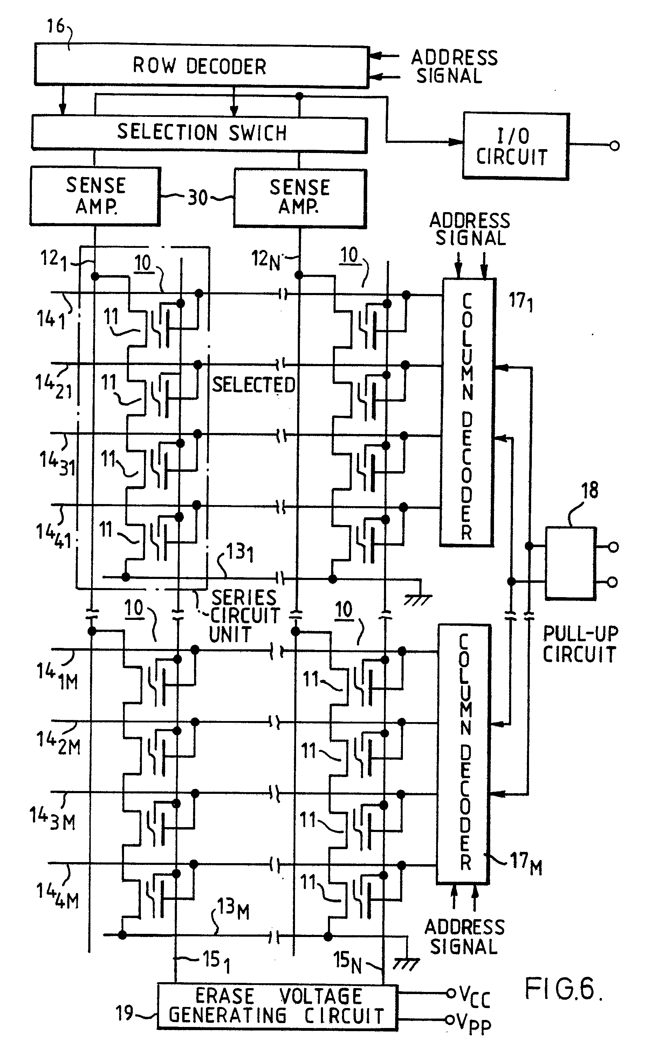

Figure 6 is a circuit diagram showing the overall construction of this embodiment together with its peripheral circuitry. The series circuit units are disposed in a matrix of M columns and N rows, with each of the M columns of circuit units having four column lines designated $14_{1n}$, $14_{2n}$, $14_{3n}$, $14_{4n}$ where n is the column number. Bit lines 12 are connected to row decoder 16 while the four column lines 14 associated with a given column of series circuit units are connected to the corresponding column decoder 17. Pulled up voltages, produced by pull-up circuit 18 by pulling-up the power source voltage Vcc and the high voltage Vpp supplied from external sources, are supplied to each column decoder $17_1$ to $17_M$. Erase lines 15 are connected to erase voltage generating circuit 19.

A typical power source voltage Vcc is 5V and a typical high voltage Vpp is 12.5V. The pulled-up voltages provided by pull-up circuit 18 are 5-10V and 20V respectively. Erase voltage generating circuit 19 generates an erase voltage of about 20V from the high voltage Vpp and selectively outputs this to erase lines 15.

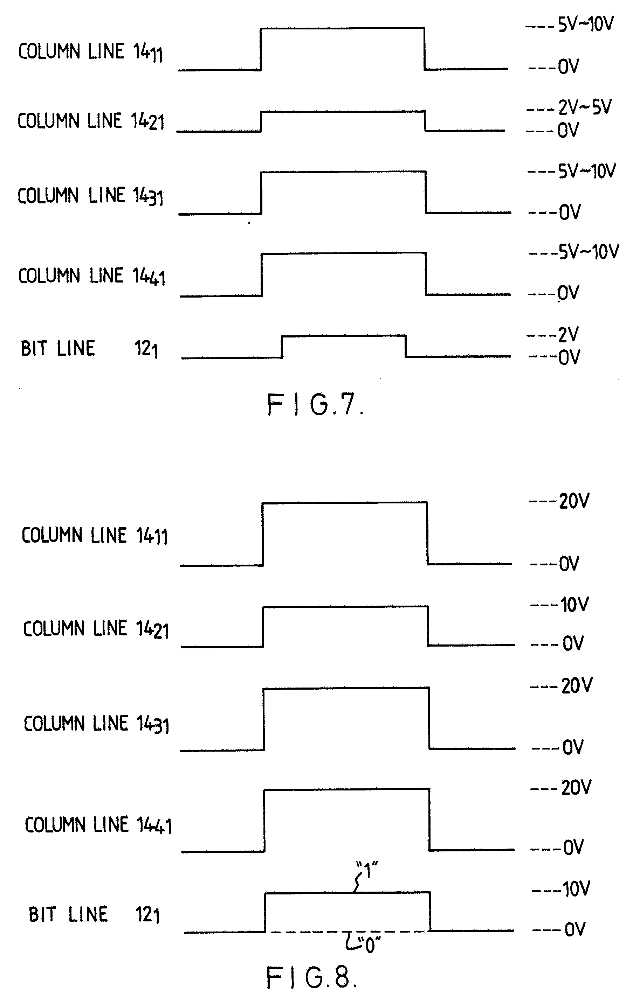

The operation of the memory shown in Figures 2 and 6 will now be described. First, the data reading operation will be described with reference to the timing chart of Figure 7. Data is to be read from a selected cell of a series circuit unit. Under the control of the output from the column decoder $17_n$ corresponding to the series circuit unit containing the selected cell, voltages are applied to the four column lines $14_{1n}$, $14_{2n}$, $14_{3n}$, $14_{4n}$. A voltage in the range 2V to 5V is applied to the column line coupled to the control gate electrode of the selected cell, while a voltage in the range 5V to 10V, generated by pull up circuit 18, is applied to the remaining three column lines. The output of the other column decoders 17 is 0V.

Suppose, for example, the series circuit unit 10 containing the selected cell is coupled to bit line $12_1$ and the four column lines $14_{11}$ to $14_{41}$. Suppose further the selected cell itself is coupled to column line $14_{21}$. Under the control of column decoder $17_1$, a voltage in the range 2V to 5V would be applied to column line $14_{21}$. The voltage applied to the remaining three column lines would be in the range 5 to 10V. Now, each memory cell 11 has had its threshold voltage set in accordance with what was written to it previously in a data write mode. A voltage in the range 2V to 5V is higher than the low threshold voltage of the cell just after erasure but lower than the high threshold voltage of the cell after a level "1" has been written to it. A voltage in the range 5V to 10V is sufficiently higher than the high threshold voltage of the cell after a level "1" has been written to it. Consequently, applying the voltages described to the four column lines $14_{11}$ to $14_{41}$ has the effect of turning ON the three memory cells whose control gate electrodes are connected to voltage in the range of 5-10V, namely those cells on column lines $14_{11}$, $14_{31}$, and $14_{41}$. However, the ON or OFF state of the selected cell, whose control gate electrode is connected to column line $14_{21}$, is determined by its threshold voltage which, as noted above, is set during the data write mode.

During data reading, a 2V read voltage is applied to bit line $12_1$ in response to the output of row decoder 16. If the threshold voltage of the selected transistor is low, corresponding to a level "0" state, the selected transistor is turned on by the voltage of column line $14_{21}$. Thus, the read voltage of 2V applied to bit line $12_1$ is discharged to ground line $13_1$ through series circuit unit 10. The ground lines 13, as previously noted, are maintained at 0V. However, if the threshold voltage of the selected transistor is high, corresponding to a level "1" state, the transistor remains off when the voltage of column line $14_{21}$ is applied. Thus, the read voltage of 2V applied to bit line $12_1$ is not discharged to ground line 13. In short, the voltage of a bit line 12 depends on whether the threshold voltage of the selected cell is high or low. The discrimination of logic levels "1" and "0" can thus be performed by amplifying the potential difference with a sense amplifier 30 connected to bit line 12. In practice, the voltage applied during data reading to the column lines 14 of the non-selected cells should normally be set at about 8V.

The data writing operation will now be described with reference to the timing charge of Figure 8. Data is to be written to a selected cell of a series circuit unit. As in data reading, voltages are applied to the four column lines $14_{1n}$, $14_{2n}$, $14_{3n}$, $14_{4n}$ under the control of the output from the column decoder $17_n$ corresponding to the series circuit unit containing the selected cell.

A pulled-up voltage of 10V is applied from pull up circuit 18 to the column line coupled to the control gate electrode of the selected cell while a pulled-up voltage of 20V is applied to the remaining three column lines. The outputs of all other column decoders 17 are 0V. As in data reading, it is assumed that the series circuit unit 10 containing the selected cell is coupled to bit line $12_1$ and the selected cell is coupled to column line $14_{21}$. Under the control of column decoder $17_1$, a voltage of 10V is applied to column line $14_{21}$. A voltage of 20V is applied to the three remaining column lines. During data writing , two different voltage levels are applied to bit line $12_1$ depending on the write data that is being output from row decoder 16. When writing a level "1", a voltage of 10V is applied to bit line $12_1$, while a voltage of 0V is applied when writing a level "0".

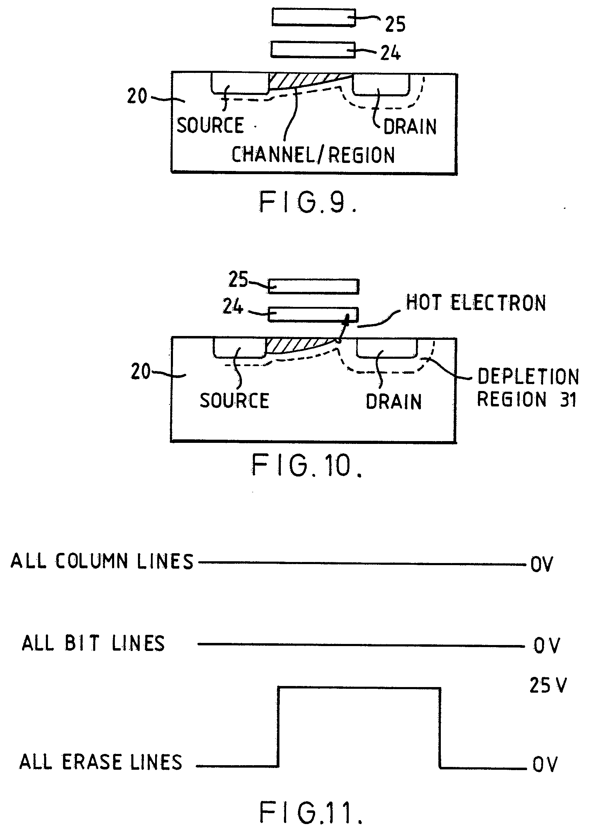

The three memory transistors 11 whose control gate electrodes are coupled to the 20V by the three column lines $14_{11}$, $14_{31}$, $14_{41}$ operate as triodes i.e., in their non-saturation state. In this operation, a channel region is formed between the source and drain regions, as shown in Figure 9.

However, the selected memory transistor, whose control gate electrode is supplied with a voltage of 10V by the column line $14_{21}$, is driven to its saturated state, as shown in Figure 10. If 10V is applied between the bit line $12_1$ and the ground line $13_1$, electrons flow from the source region of the four cells 11 in the series circuit unit 10 towards the drain region. The electric field is concentrated in the depletion layer 31 generated, particularly in the vicinity of the drain region of the selected memory transistor 11. As a result, electrons are accelerated and given sufficient energy to cross the energy barrier of the insulating film from the surface of substrate 20 in Figure 10. These electrons are called "hot electrons". They are drawn toward the control gate electrode 25 of the selected cell which is set to the voltage of 10V and fly into the floating gate electrode where they are captured. As a result, the floating gate electrode 24 of the selected cell becomes negatively charged, causing the threshold voltage to rise to a high level.

If a voltage of 0V is applied to bit line $21_1$, the hot electrons are not generated and the threshold voltage stays in its original low state. Thus, data may be written to each individual cell.

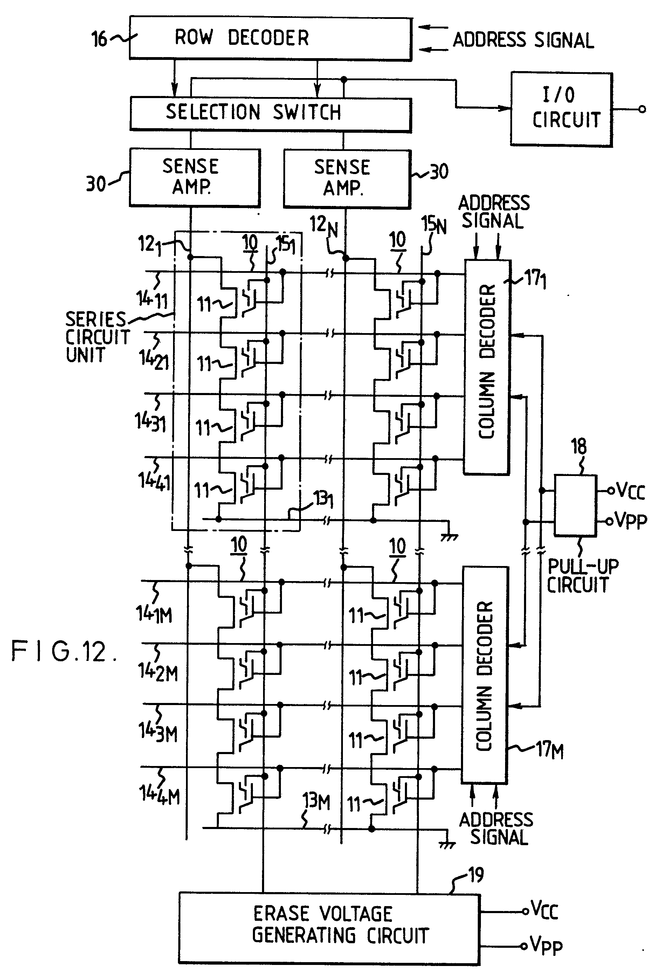

The data erasure will now be described. In data erasure, as shown by the timing chart of Figure 11, all of the column lines 14 and bit lines 12 are set to 0V by the output of row decoder 16 and column decoders 17. All the erase lines 15 are set to the high voltage of 25V by the output of erase voltage generating circuit 19. A high voltage of 25V is therefore applied to the erase gate electrodes of each cell. As a result, field emission takes place between the floating gate electrode and erase electrode of each cell, causing the electrons that had accumulated at the floating gate electrode to be emitted to the erase gate electrode. As a result, the threshold voltages of each cell return to the low condition and all the cells are erased simultaneously.

During data erasure, erasure of cell data in series circuits 10 can be effected in units of rows by selectively applying the high voltage of 25V from erase voltage generating circuit 19 only to particular erase lines 15.

Using the processes described above, data may be read and written in bit units and may be erased either simultaneously from all the cells or in units of rows. More importantly, these processes can be carried out in an array requiring one bit line and one erase line per series circuit unit, which in the above embodiment, comprises four cells. This is in marked contrast to prior art arrays where a bit line and an erase line were required for each bit or cell. Thus, utilizing the present invention, it is possible to produce memory cell arrays with a high integration density. In addition, fewer contacts are required to connect the cells with a bit line. The present invention requires one contact with the bit line for every four cells. This can lead to an increase in production yield.

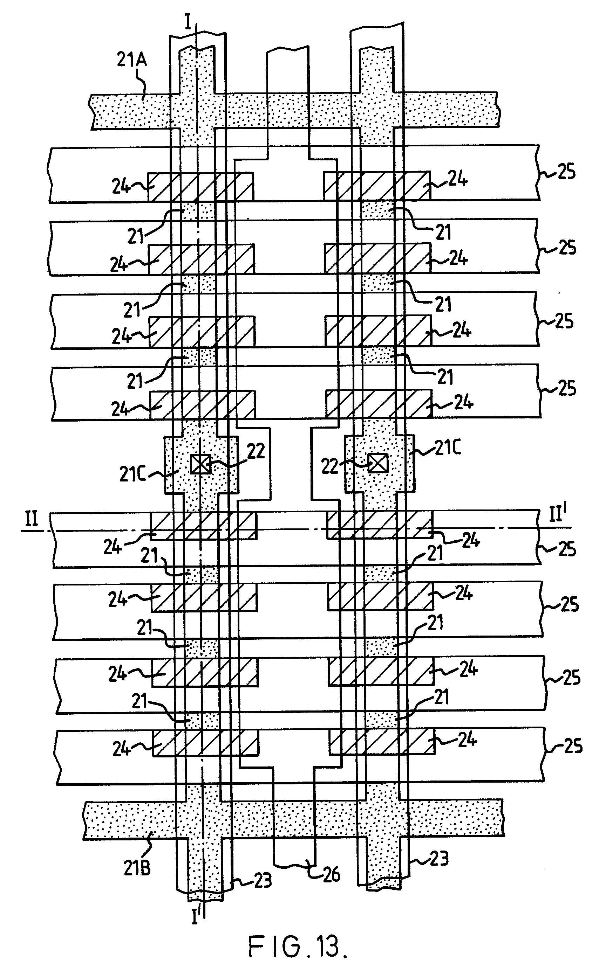

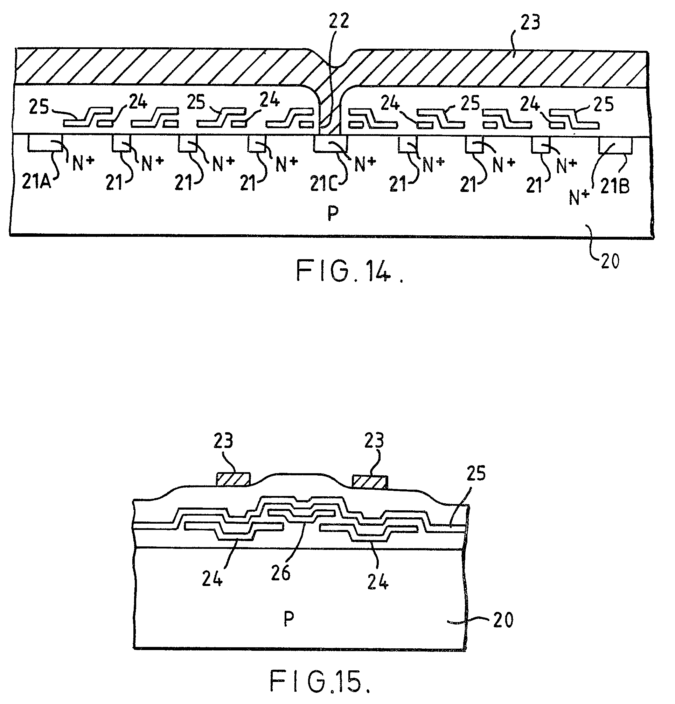

Figures 12 to 15 show another embodiment of this invention. Figure 12 is a circuit diagram showing the overall construction of this embodiment together with its peripheral circuitry. In this memory, series circuit unit 10 consists of four cells 11 connected in series. Again, in practice various numbers of cells may be used and this embodiment should not be understood as limited in this respect. The cells 11 comprise the series connection of a floating gate electrode transistor having an erase gate electrode with an enhancement type MOS transistor. Figure 13 is a plan view of the pattern of the structure of the memory cell array in Figure 12. Figure 14 is a cross-sectional view along the line I - I' in Figure 13. Figure 15 is a cross-sectional view along the line II - II' in Figure 13.

Each of the memory cells 11 comprising series circuit unit 10 includes a non-volatile transistor having: a source region; a drain region; a floating gate electrode arranged above the channel region along part of the channel length between the source and drain region; a control gate electrode provided over the floating gate electrode and across the channel region where the floating gate electrode is not provided; an an erase gate electrode arranged so as to overlap the floating gate electrode. The control gate of the non-volatile transistor also functions as the gate electrode of the enhancement type MOS transistor connected in series.

In Figures 13, 14, and 15, electrodes 24, made of a first polycrystalline silicon layer and put in a floating electrical state, are formed over the channel region between adjacent N+ type regions 21 along part of the channel length and are insulated therefrom by an insulating film. Electrodes 24 are the floating gate electrodes of each memory cell 11. Electrodes 25, made of a third polycrystalline silicon layer, are formed over the plurality of electrodes 24, insulated therefrom by an insulating film, and over the channel regions where the electrodes 24 are not provided. Electrodes 25 are the control gate electrodes and the gate electrodes of the enhancement MOS transistor and serve as the column line 14 of each memory cell 11. Electrodes 26, made of a second polycrystalline silicon layer, are formed between adjacent rows of series circuit units 10, insulated therefrom by an insulating film. These electrodes 26 overlap part of electrodes 24 which, as noted, are the floating gate electrodes of each cell. Electrodes 26 are the erase gate electrodes and serve as the erase line 15 of each memory cell 11. In this embodiment, the enhancement MOS transistor is switched by the signal of control gate electrode 25 of the floating gate transistor during the reading and writing modes.

This invention is not restricted to the above embodiments and may be modified in various ways. For example, in the above embodiment during data reading, a voltage in the range of 2V to 5v was applied to the column line 14 that was coupled to the selected cell, while a voltage in the range 5V to 10V was applied to the remaining three column lines. These voltages should be set in accordance with the threshold voltage corresponding to the level "1" and level "0" of memory cell 11. The 2V read voltage applied to bit line 12 may also be altered as required. It is desirable to set this read voltage as low as possible to suppress what is known as the "soft write" phenomenon during the read mode.

Furthermore, in the above embodiments during data writing, a voltage of 10V was applied only to the column line 14 that was coupled to the selected cell and a voltage of 20V was applied to the remaining three column lines. These voltages actually need only be high enough to inject a sufficient number of electrons into the floating gate electrode of the selected cell by its saturation operation and to drive the non-selected cells to their non-saturation state (triode operation).

In addition, although the memory of the above embodiments series circuit unit 10 comprised four memory cells in series, the series connection of 8, 16 or 32 memory cells may be employed. If, for example, series circuit 10 comprises 8 memory cells in series, the degree of integration may be increased 2 or more times over that of the prior art memory. This combined with the increase in the density of circuit integration can result in a considerable reduction in costs.

The above embodiment was described assuming that the electrodes 25 in Figure 3, serving as the control gate electrodes and column lines 14 of each cell, were made of a polycrystalline silicon. However, other high melting-point metallic silicides, such as titanium silicide, molybdenum silicide, or other melting-point metals, may be used.

Further, although in the above embodiments erasure of the data was effected for all the cells at once, they may be erased a row at a time.

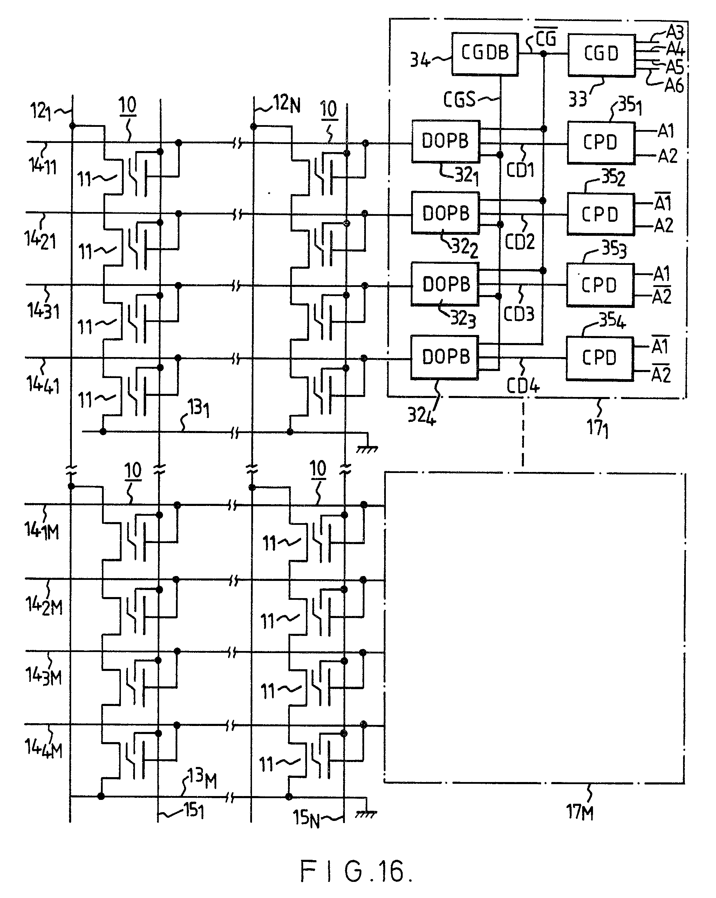

Figures 16-23 illustrate the details of the peripheral circuitry associated with the embodiments of Figures 6 and 12 and will now be discussed. Figure 16 is a circuit diagram of the entire circuit, showing in detail that portion of a column decoder 17 which applies a high voltage of 10V or 20V to the column lines 14 in order to write data into the memory shown in Figures 6 and 12. One of column decoders $17_1$ to $17_M$ is activated by a 4-bit address consisting of bits A3, A4, A5, and A6. The decoded output of the activated column decoder 17 selects a plurality of series circuits 10 coupled together in the corresponding column of series circuit units. In addition, one of the four column lines coupled to this plurality of series circuits 10 is selected by a 2-bit address consisting of bits A1 and A2.

Each column decoder 17 is provided with a column group decoder (CGD) 33 coupled to receive the 4-bit address, i.e., a combination of address bits A3, A4, A5, and A6, each bit having either a positive or negative phase. The decoded output of CGD 33, CG, is supplied to column-group decoder buffer (CGDB) 34. It is simultaneously supplied to the four decoder-output buffers (DOPBs) $32_1$ to $32_4$, which are provided for each of the four column lines 14 and which output the high voltage of 10V or 20V. The output CGS of CGDB 34 is also supplied to DOPBs $32_1$ to $32_4$.

Each column decoder 17 is also provided with four column part decoders (CPDs) $35_1$ to $35_4$, each coupled to receive the 2-bit address, i.e., a combination of address bits A1 and A2, each bit having either a positive or negative phase. The decoded outputs CD1 to CD4 of CPDs $35_1$ to $35_4$ are supplied to the corresponding one of DOPBs $32_1$ to $32_4$. DOPBs $32_1$ to $32_4$ output the high voltage of 10V or 20V or a ground voltage of 0V to the corresponding column line 14 in response to the output CG of CGD 33, the output CGS of CGDB 34, and the outputs of CPDs 35.

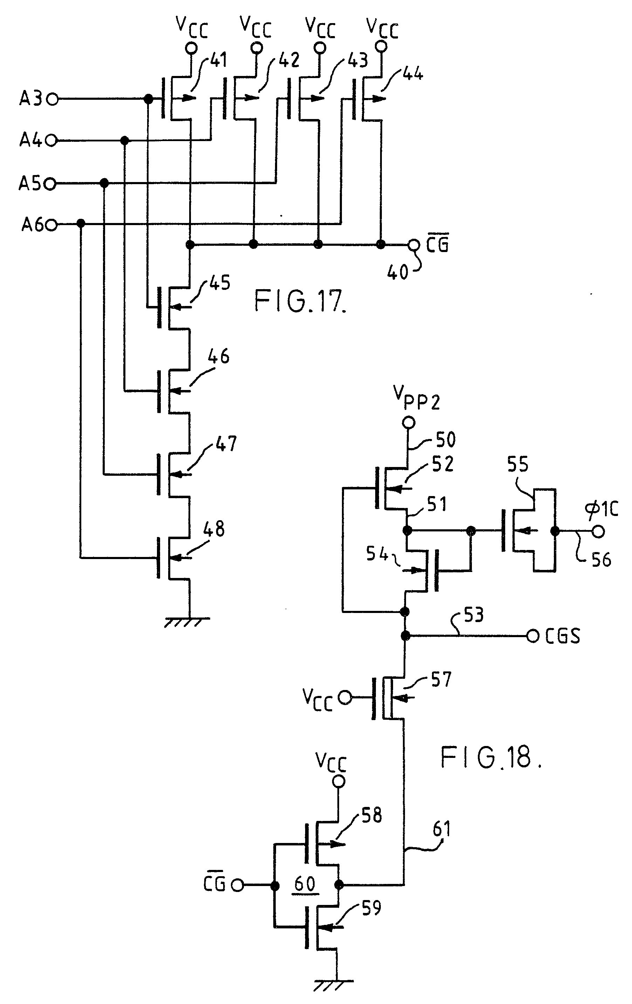

Figure 17 is a circuit diagram showing, in detail, the CGD 33 provided for each column decoder 17. CGD 33 comprises four P-type MOS transistors 41 to 44 and four N-type MOS transistors 45 to 48. Transistors 41 to 44 are connected in parallel, each coupled between power-source voltage terminal Vcc and node 40 for the output signal CG. Address bits A3, A4, A5, and A6 are supplied to the gates of MOS transistors 41 to 44, respectively. Transistors 45 to 48 are connected in series, coupled between output node 40 and the ground. Address bits A3, A4, A5, and A6 are supplied to the gates of these transistors 45 to 48, respectively. The CGDs 33 provided in other column decoders 17 have the same structure, but the phases of address bits A3, A4, A5, and A6 differ.

Figure 18 is a circuit diagram showing, in detail, CGDB 34 provided for each column decoder 17. N-type MOS transistor 52 is coupled between nodes 50 and 51. High voltage Vpp2 is applied to node 50. An N-type MOS transistor 54 is connected between node 51 and node 53 for output signal CGS. The gate of transistor 52 is also coupled to node 53. The gate of transistor 54 is coupled to node 51. Capacitor 55 comprising an N-type MOS transistor is connected, at one end, to node 51. The other end of capacitor 55 is coupled to node 56 for receiving clock signal 1C. Depletion-type N-type MOS transistor 57 is connected, at one end, to node 53. The other end of transistor 57 is connected to the output node 61 of CMOS inverter 60. CMOS inverter 60 is comprised of P-type MOS transistor 58 and N-type MOS transistor 59 and is coupled to receive the decoded output CG of CGD 33. Voltage Vcc is supplied to the gate of depletion-type transistor 57 at all times. All transistors used in this circuit, except for transistor 57, are enhancement-type.

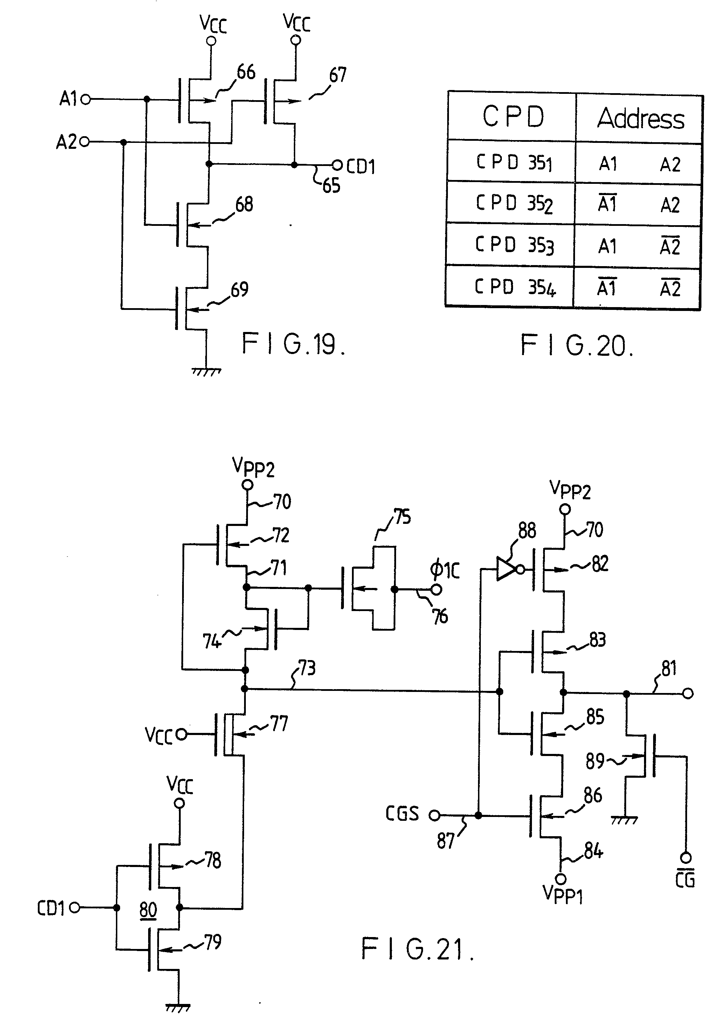

Figure 19 is a circuit diagram showing, in detail, one of the CPDs 35 provided in each column decoder 17. More precisely, it depicts CPD $35_1$ to which address bits A1 and A2 are input. Two P-type MOS transistors 66 and 67 are connected in parallel, each coupled between power-source voltage terminal Vcc and node 65 for output signal CD1. Address bits A1 and A2 are supplied to the gates of transistors 66 and 67 respectively. N-type MOS transistors 68 and 69 are connected in series, coupled between node 65 and the ground. Address bits A1 and A2 are supplied to the gates of transistors 68 and 69 respectively. The other CPDs 35 have the same structure as the CPD shown in Figure 19, but the phases of the input address bits differ. As shown in Figure 20, bits A1 and A2 are input to CPD $35_2$; bits A1 and A2 are input to CPD $35_3$; and bits A1 and A2 are input to CPD $35_4$.

Figure 21 is a circuit diagram showing, in detail, one of DOPBs 32 provided in each column decoder 17. N-type MOS transistor 72 is coupled between nodes 70 and 71. High voltage Vpp2 is supplied to node 70. N-type MOS transistor 74 is coupled between node 71 and node 73. The gate of transistor 72 is coupled to node 73 and the gate of transistor 74 is coupled to node 71. Capacitor 75 comprising an N-type MOS transistor is coupled, at one end, to node 71. The other end of capacitor 75 is connected to node 76 to which clock signal o1C is supplied. Depletion-type, N-type MOS transistor 77 is connected, at one end, to node 73. Voltage Vcc is always supplied to the gate of transistor 77. The other end of transistor 77 is connected to the output node of CMOS inverter 80 comprising P-type MOS transistor 78 and N-type MOS transistor 79 and which is coupled to receive the decoded output CDi of CPD 35i.

In addition, two P-type MOS transistors 82 and 83 are connected in series between nodes 70 and 81. Node 81 is coupled to column line 14. Two N-type MOS transistors 85 and 86 are connected in series between nodes 81 and 84. High voltage Vpp1 is supplied to node 84. The gate of MOS transistor 82 is coupled through inverter 88 to node 87, to which signal CGS output from CGDB 34 is supplied. The gate of transistor 86 is directly connected to node 87. The gates of transistors 83 and 85 are coupled to node 73. N-channel MOS transistor 89 is coupled between node 81 and the ground. The gate of transistor 89 is coupled to receive signal CG from CGD 33. All transistors used in this circuit, except for transistor 77, are enhancement-type.

Assume that all address bits A1 to A6 are set to level "1" in order to write data into the memory of the structure shown in Figure 16. Then, the decoded output CG of CGD 33 of column decoder $17_1$, and the decoded output CD1 of CPD $35_1$ also of decoder $17_1$ are set to "0". More specifically, in the CGD 33 shown in Figure 17, the four address bits A3 to A6 are all set to level "1", turning P-type MOS transistors 41 to 44 off and N-type MOS transistors 45 to 48 on. As a result, output node 40 is discharged through transistors 45 to 48, and the signal CG obtained at node 40 is set to level "0", i.e., 0V. In CPD $35_1$ shown in Figure 19, two address bits A1 and A2 are set to level "1", turning N-type MOS transistors 68 and 69 on. Therefore, node 65 is discharged via transistors 68 and 69, and signal CD1 is also set to level "0", i.e., 0V. In the other CPDs $35_2$ to $35_4$ provided in column decoder $17_1$, one of address bits A1 or A2 is set to level "0". Hence, at least one of the two P-type MOS transistors 66 and 67 is turned on. As a result, signals CD2 to CD4 are set to level "1", i.e., Vcc.

When signal CG is set to "0", the output signal CGS of CGDB 34 is set to a voltage equal to or higher than Vpp2. More specifically, in CGDB 34 shown in Figure 18, the output node 61 of CMOS inverter 60 is set to "1" (Vcc) when signal CG is set to "0". Since voltage Vcc is applied to the gate of depletion-type transistor 57, node 53 is also set to "1" (Vcc). Transistor 52 is thereby turned on, and node 51 is quickly charged with the high voltage Vpp2 applied to node 50. Thus, transistor 54 is also turned on and node 53 is charged with high voltage Vpp2. Thereafter, the voltage at node 53 is raised every time clock signal 1C changes from "0" to "1" due to the coupling capacitance of capacitor 55 with transistor 54 functioning as a rectifying element. The signal CGS obtained at node 53 is set to a level equal to or higher than Vpp2.

DOPB $32_1$, which receives the output CG of CGD 33, the output CGS of CGDB 34, and the output CD1 of CDP $35_1$, outputs a high voltage Vpp1 of 10V to the selected row line $14_{11}$. More specifically, in DOPB 32 shown in Figure 21, transistor 86 is turned on since signal CGS is set to a high voltage of 20V or more. The output of inverter 88, to which signal CGS is input, is set to "0". Hence, transistor 82 is also turned on. Since the decoded output CD1 of CPD $35_1$ is "0" at this time, a high voltage of 20V or more is output to node 73, as in the circuit of Figure 18. As a result, transistor 85 is turned on. At this time, the output CG from CGD 33 is "0", and transistor 89 is off. Therefore, node 81 is charged with voltage Vpp1 through transistors 86 and 85. Since a high voltage of 20V or more is applied to the gates of both transistors 86 and 85 at this time, Vpp1 of 10V is applied directly to node 81.

In each of other DOPBs $32_1$ to $32_4$ provided in column decoder $17_1$, which are coupled to the column lines other than selected row line $14_{11}$, the decoded outputs CD2 to CD4 of CPD $35_2$ to $35_4$ are set to "1", and node 73 is set to the ground voltage. Therefore, in the circuit of Figure 21, transistor 83 is turned on, transistor 85 is turned off, and node 81 is charged with voltage Vpp2 through transistors 82 and 83. Hence, DOPBs $32_2$ to $32_4$ of column decoder $17_1$ output a high voltage 20V to column lines $14_{21}$, $14_{31}$, and $14_{41}$, respectively.

In any column decoder other than decoder $17_1$, the decoded output CG of CGD 33 is set to "1", turning the transistor 89 provided in each DOPB 32 (Figure 21) on. As a result, the output voltage of DOPB 32 is 0V, i.e., the ground voltage.

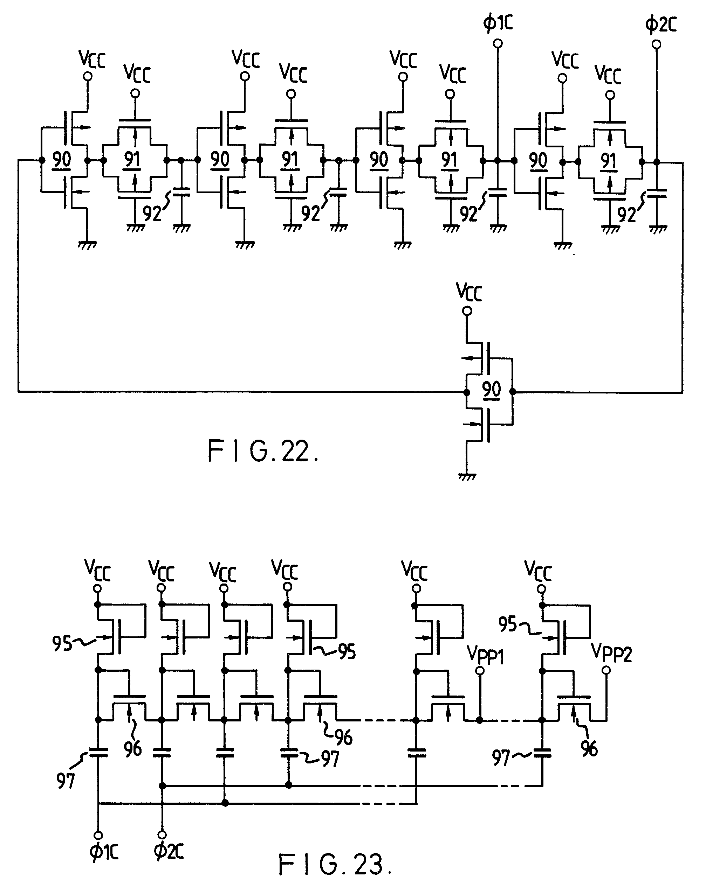

Figure 22 is a circuit diagram showing an oscillation circuit for generating clock signal 1C and clock signal 2C (described later), for use in the circuits of Figures 18 and 21. This oscillation circuit is known in the prior art as a ring oscillator. It comprises an odd number of CMOS inverters 90, for example five, connected in cascade and each made of a P-type and N-type MOS transistor. Transfer gates 91 are connected between these inverters and function as resistive elements, each comprising a P-type and an N-type MOS transistor. Capacitors 92 are coupled to the connection point of the adjacent CMOS inverter and transfer gate.

Figure 23 is a circuit diagram illustrating a PULL UP circuit for generating high voltages Vpp1 and Vpp2 used in column decoder 17. This circuit is of the well-known charge-pump type. It comprises a plurality of PULL UP units connected in cascade. Each unit comprises an N-type MOS transistor 95 functioning as a load transistor, N-type MOS transistor 96 functioning as a rectifying transistor, and a capacitor 97. Clock signals 1C and 2C, which have been obtained by the oscillation circuit shown in Figure 22, are alternately input to one end of capacitor 97.

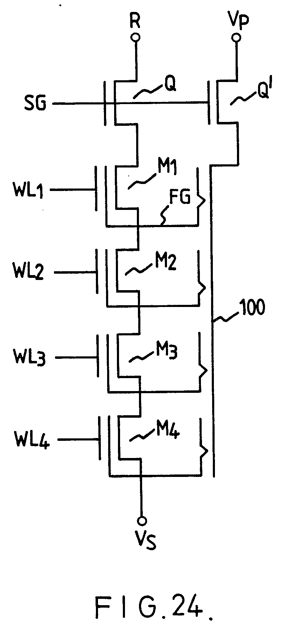

Figure 24 is a circuit diagram of a further embodiment. In the Figure, $N^+$ region (100) is arranged in parallel with NAND type memory cells M1 ~ M4. Floating gate (FG) is arranged above the $N^+$ region (100) through a thin oxide layer. The operations of programing and eraseing are performed between the floating gate and the $N^+$ region.

During the memory is programed, programing voltage ($V_p$) is applied to the $N^+$ region (100) through a transistor $Q^7$. And, a drain of a transistor Q is used as a terminal of reading.

It is to be noted that the plurality of series connected memory cells may comprise four, eight, sixteen or thirty-two non-volatile transistors. In general, erasure may be effected by the selective application of a high voltage generated by an erase voltage generating circuit to the erase lines.

While the foregoing description is directed to only a few presently preferred emnbodiments it will be obvious to one or ordinary skill that numerous modifications may be made without departing from the scope of the invention which is to be limited only by the appended claims.

## Claims

1. A non-volatile semiconductor memory comprising:
a first power source terminal;
a second power source terminal;
a plurality of memory cells (11); and
means for selecting a particular transistor, characterised in that
the plurality of memory cells (11) are connected in series between the power source terminals, the memory cells (11) each consisting of non-volatile transistors having a control gate electrode, a floating gate electrode, and an erase gate electrode for electrically erasing data stored in each memory cell; and in that
the said means are for selecting a particular transistor by selectively applying a first voltage to the control gate electrode of said selected non-volatile transistor and a second voltage to the control gate electrodes of the remaining non-selected non-volatile transistors wherein the first voltage is set for driving the selected transistor to its saturation state while the second voltage is set for driving the non-selected transistors to their non-saturation state.

2. The non-volatile semiconductor memory according to claim 1 wherein
the first power source terminal is a bit line and the second power source terminal is a ground line.

3. The non-volatile semiconductor memory according to claim 1, wherein the plurality of series connected memory cells comprises four, eight, sixteen or thirty-two non-volatile transistors.

4. A non-volatile semiconductor memory comprising:
a plurality of circuit units arranged in a row and column matrix, characterised by
each circuit unit comprising at least two memory cells (11) connected in series, wherein each memory cell consists of a non-volatile transistor having a control gate electrode, a floating gate electrode, and an erase gate electrode for electrically erasing data stored in the cell;
a plurality of bit lines (12), one end of each circuit unit coupled to one of the bit lines, with the circuit units in a given row of circuit units being coupled to the same bit line; and
a plurality of column lines (14), each circuit unit in a given column of circuit units having the control gate electrodes of its memory cells coupled to a column line, with the control gate electrodes of each memory cell (11) in a given column of memory cells being coupled to the same column line.

5. The non-volatile semiconductor memory according to claim 4 wherein said circuit unit comprises four memory cells.

6. The non-volatile semiconductor memory according to claim 4 wherein
the column line is comprised of a polycrystalline silicon or a high-melting point metallic silicide.

7. The non-volatile semiconductor memory according to claim 6 wherein the high-melting point metallic silicide is titanium silicide or molybdenum silicide.

8. The non-volatile semiconductor memory as claimed in claim 4 and further characterised by means for selecting a particular memory cell within a circuit unit by selectively applying a first voltage to the column line associated with said selected memory cell and a second voltage to the remaining column lines associated with the remaining memory cells within said circuit unit.

9. The non-volatile semiconductor memory according to claim 8 wherein
the first voltage drives the selected memory cell within a circuit unit to its saturation state and the second voltage drives the remaining memory cells within a circuit unit to their non-saturation state.

10. The non-volatile semiconductor memory according to claim 9 wherein
during the reading of data from said cells, the first voltage is higher than the threshold voltage of the memory cell corresponding to a level "O" and lower than the threshold voltage of the non-volatile transistor corresponding to a level "1" and the second voltage is higher than the threshold voltage corresponding to a level "1".

11. The non-volatile semiconductor memory according to claim 8 and 14 wherein erasure is effected by the selective application of a high voltage generated by an erase voltage generating circuit to the erase lines.

12. The non-volatile semiconductor memory according to claim 10 wherein
the second voltage applied to the column lines is generated by a pull-up circuit that pulls up an external power source voltage.

13. A non-volatile semiconductor memory as claimed in claim 4 and further characterised in that
the floating gate electrode of each memory cell is formed over part of a channel region, the erase gate electrode overlaps the floating gate electrode and the control gate electrode extends over the floating gate electrode and over the remaining part of the channel region where the floating gate electrode has not been formed.

14. A non-volatile semiconductor memory as claimed in claim 4, 8 or 13, further characterised by

a plurality of erase lines, the erase gate electrodes of each memory cell in a circuit unit being coupled to a common erase line.

15. A non-volatile semiconductor memory as claimed in claim 14 wherein
the circuit units in a given row of circuit units are coupled to the same erase line.

16. A non-volatile semiconductor as claimed in claim 4 and further characterised in that the floating gate electrode of each memory cell is formed over a channel region and positioned between a source and drain region defined by the floating gate, the erase electrode overlaps the floating gate electrode and the control gate electrode is formed over the floating gate electrode and positioned between said source and drain regions.

F I G.1.
(PRIOR ART)

F I G. 2.

FIG.3.

F I G.4.

F I G.5.

EP 0 317 323 A2

FIG.6.

COLUMN LINE 14₁₁

---5V~10V

---0V

COLUMN LINE 14₂₁

--- 2V~5V

--- 0V

COLUMN LINE 14₃₁

---5V~10V

---0V

COLUMN LINE 14₄₁

---5V~10V

---0V

BIT LINE 12₁

---2V

---0V

F I G.7.

COLUMN LINE 14₁₁

---20V

---0V

COLUMN LINE 14₂₁

---10V

--- 0V

COLUMN LINE 14₃₁

---20V

---0V

COLUMN LINE 14₄₁

---20V

---0V

BIT LINE 12₁

"1"

---10V

---0V

"0"

F I G.8.

FIG.9.

FIG.10.

FIG.11.

F I G.12.

FIG. 13.

FIG.14.

FIG.15.

EP 0 317 323 A2

F I G .16.

FIG.17.

FIG.18.

F I G.19.

F I G.20.

| CPD | Address | |
|---|---|---|
| CPD 35₁ | A1 | A2 |
| CPD 35₂ | $\overline{A1}$ | A2 |
| CPD 35₃ | A1 | $\overline{A2}$ |
| CPD 35₄ | $\overline{A1}$ | $\overline{A2}$ |

F I G.21.

F I G. 22.

F I G. 23.

F I G. 24.